(19) Europäisches Patentamt
European Patent Office
Office européen des brevets

(11) **EP 4 332 997 A1**

(12) **EUROPEAN PATENT APPLICATION**
published in accordance with Art. 153(4) EPC

(43) Date of publication:
**06.03.2024 Bulletin 2024/10**

(51) International Patent Classification (IPC):
***H01B 17/56*** *(2006.01)*      ***H05K 1/03*** *(2006.01)*

(21) Application number: **22795874.1**

(52) Cooperative Patent Classification (CPC):
**H01B 17/56; H05K 1/03**

(22) Date of filing: **27.04.2022**

(86) International application number:
**PCT/JP2022/019184**

(87) International publication number:
**WO 2022/230961 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.04.2021 JP 2021075897**

(71) Applicant: **Kyocera Corporation**
**Kyoto-shi Kyoto 612-8501 (JP)**

(72) Inventors:
• **CHIKARA, Chie**
**Kyoto-shi, Kyoto 612-8501 (JP)**
• **NAGASAWA, Tadashi**
**Kyoto-shi, Kyoto 612-8501 (JP)**
• **YOSHIURA, Satoshi**
**Kyoto-shi, Kyoto 612-8501 (JP)**
• **FUJIKAWA, Kouji**
**Kyoto-shi, Kyoto 612-8501 (JP)**
• **IMAZATO, Taishi**
**Kyoto-shi, Kyoto 612-8501 (JP)**

(74) Representative: **Viering, Jentschura & Partner
mbB**
**Patent- und Rechtsanwälte**
**Am Brauhaus 8**
**01099 Dresden (DE)**

(54) **ORGANIC INSULATOR, METAL-CLAD LAMINATE, AND WIRING BOARD**

(57)    An organic insulator of the present disclosure includes an organic resin as a main component, and the organic resin includes at least a nitrogen atom-containing antioxidant (A) and a phenol-based antioxidant (B). A metal-clad laminate sheet includes the organic insulator described above and a metal foil laminated on at least one surface of the organic insulator. A wiring board includes: a plurality of insulating layers, each of the plurality of insulating layers including the organic insulator described above; and a metal foil disposed between the insulating layers.

**EP 4 332 997 A1**

**Description**

TECHNICAL FIELD

The present disclosure relates to an organic insulator, and a metal-clad laminate sheet and a wiring board using the organic insulator.

BACKGROUND OF INVENTION

In recent years, advancements such as an acceleration in LSI developments and increases in integration levels and memory capacity have been progressing, and in association therewith, decreases in the size, weight, and thickness of various electronic components have been rapidly advancing. Known wiring boards used in the field of such electronic components use, as insulating materials, cyclic olefin copolymers like those disclosed in Patent Document 1, for example. Such insulating materials are used, for example, in copper-clad substrates and wiring boards for high frequency applications in which copper foil is bonded to a surface thereof.

CITATION LIST

PATENT LITERATURE

Patent Literature 1: JP 2010-100843 A

SUMMARY

An organic insulator of the present disclosure includes an organic resin phase as a main component, and the organic resin phase includes at least a nitrogen atom-containing antioxidant (A) and a phenol-based antioxidant (B).
A metal-clad laminate sheet of the present disclosure includes the organic insulator described above and a metal foil laminated on at least one surface of the organic insulator.
A wiring board of the present disclosure includes: a plurality of insulating layers, each of the plurality of the insulating layers including the organic insulator described above; and a metal foil disposed between the insulating layers.

DESCRIPTION OF EMBODIMENTS

The organic insulator of the present disclosure includes an organic resin as a main component. The organic resin includes a nitrogen atom-containing antioxidant (A) and a phenol-based antioxidant (B). Here, the phrase "containing an organic resin as a main component" means that a proportion of the organic resin contained in the organic insulator is 60 mass% or more.
The nitrogen atom-containing antioxidant (A) (hereinafter sometimes referred to as "nitrogen-based antioxidant (A)") can be, for example, a hindered amine-based compound. The phenol-based antioxidant (B) may be, for example, a di-t-butylphenol derivative. The dit-butylphenol derivative is preferably a compound containing a di-t-butylhydroxyphenyl group in its structure.
At a high temperature, the nitrogen-based antioxidant (A) is weakened in antioxidant effect or undergoes a reaction by which its activity is lost. On the other hand, the phenol-based antioxidant (B) containing di-t-butylphenol can react even at a high temperature and has a function of reactivating the deactivated nitrogen-based antioxidant (A). Therefore, oxidation of the organic insulator may be further prevented, and increases in relative dielectric constant and dielectric loss tangent can be suppressed. On the other hand, the phenol-based antioxidant (B) alone is difficult to mix with the organic resin due to a large polarity, resulting in a weak antioxidant effect. The presence of the nitrogen-based antioxidant (A) and the phenol-based antioxidant (B) makes them easier to mix with the organic resin, and the antioxidant effect can be further exhibited.
That is, when the organic insulator is left at a high temperature of, for example, 125°C for a long period of time, the oxidation of the organic resin as the main component of the organic insulator can be suppressed. This makes it possible to suppress an increase in dielectric loss tangent (Df) particularly in a high-temperature environment. In addition, due to the organic insulator containing the two antioxidants (A) and (B) described above, a decrease in glass transition point (Tg) of the organic resin can be suppressed.
A ratio (A/B) of the nitrogen-based antioxidant (A) to the phenol-based antioxidant (B) is preferably 0.5 or more and 3.1 or less in terms of mass ratio. As a result, the dielectric loss tangent (Df) after the organic insulator is left at 125°C for 2000 hours can be 0.0045 or less. The ratio (A/B) of the nitrogen-based antioxidant (A) to the phenol-based antioxidant (B) is preferably 0.5 or more and 3.0 or less in terms of mass ratio. As a result, the dielectric loss tangent (Df) after the organic insulator is left at 125°C for 2000 hours can be 0.0038 or less.

A total amount of the nitrogen-based antioxidant (A) and the phenol-based antioxidant (B) is preferably 0.7 parts by mass or more and 4.5 parts by mass or less with respect to 100 parts by mass of the organic resin. As a result, the dielectric loss tangent (Df) after the organic insulator is left at 125°C for 2000 hours can be suppressed to 0.0045 or less.

The total amount of the nitrogen-based antioxidant (A) and the phenol-based antioxidant (B) is preferably 0.9 parts by mass or more and 2.1 parts by mass or less with respect to 100 parts by mass of the organic resin. As a result, the dielectric loss tangent (Df) at 125°C after the organic insulator is left for 2000 hours can be 0.0037 or less.

Contents of the nitrogen-based antioxidant (A) and the phenol-based antioxidant (B) contained in the organic resin can be measured, for example, by pyrolysis gas chromatography-mass spectrometry (GC-MS). That is, components contained in the resin are analyzed from a gas generated by burning the organic resin at 600°C in a helium stream.

The antioxidants (A) and (B) are preferably contained more in a surface region of the organic insulator than in an inner region thereof. Upon heating of the organic resin in an air atmosphere, the resin and oxygen are bonded to each other and the polarity is increased. On the other hand, the presence of the nitrogen-based antioxidant (A) more in the surface region of the organic resin than in the interior thereof can suppress the bonding between the resin and oxygen in the surface region of the organic insulator.

Here, the "surface region of the organic insulator" means a range of a depth of about 20 $\mu$m from a surface of the organic insulator, including the surface. On the other hand, the inner region is a portion deeper than 20 $\mu$m from the surface. In other words, the surface region of the organic insulator preferably has a depth from a main surface at a ratio of from 0.05 to 0.3 when a thickness of the organic insulator is 1. On the other hand, the inner region of the organic insulator preferably has a thickness ratio in a range of from 0.4 to 0.9 when the thickness of the organic insulator is 1.

The expression that "content proportions of the antioxidants (A) and (B) are higher in the surface region than in the inner region" means that a total content proportion of the antioxidants (A) and (B) in the surface region is 2 or more when the total content proportion of the antioxidants (A) and (B) contained in the inner region is 1. In this case, the total content proportion of the antioxidants (A) and (B) in the surface region is preferably 4 or less.

Distributions of the antioxidants (A) and (B) contained in the organic insulator are determined as follows. First, the surface of the organic insulator is polished very thinly. Next, an exposed new surface of the organic insulator is subjected to X-ray photoelectron spectroscopy (XPS).

In this case, a distribution of a specific element detected from a region other than the organic resin is examined. For the content proportions of the antioxidants (A) and (B), for example, comparison in count of an element indicated by an X-ray spectrometer (XPS) is made between in the inner region of the organic insulator and in the surface region thereof.

The contents of the antioxidants (A) and (B) in the surface region are determined from an average value of counts of the element indicated by the X-ray spectrometer (XPS) in a range of the surface region described above. On the other hand, the contents of the antioxidants (A) and (B) in the inner region are determined from an average value of counts obtained by performing X-ray spectroscopy (XPS) at 3 to 5 places in a central portion in a thickness direction of the organic insulator. A portion containing large amounts of the antioxidants (A) and (B) is preferably the entire surface of the organic insulator, but may be provided only in a portion where maintenance of properties is required. Structural formulae of the antioxidants (A) and (B) are preferably determined using a Fourier transform infrared absorption spectrometer (FT-IR) and a liquid chromatograph (HPLC). The contents of the antioxidants (A) and (B) are compared based on the number of counts obtained by X-ray spectroscopy (XPS). In this case, the contents of the antioxidants (A) and (B) are higher when the number of counts obtained by X-ray spectroscopy (XPS) is higher, whereas the contents of the antioxidants (A) and (B) are lower when the number of counts is lower.

In order that the antioxidants (A) and (B) are contained more in the surface region of the organic insulator than in the inner region thereof, for example, a sheet-shaped molded body containing the antioxidants more on a surface layer side than on an inner layer side is used when a laminated body is prepared.

In this organic insulator, the antioxidants (A) and (B) are preferably distributed in a layer shape. When a portion having high content proportions of the antioxidants (A) and (B) has a layer shape in the surface region of the organic insulator, a region having high concentrations of the antioxidants (A) and (B) can be provided in a range having a small thickness in the surface region of the organic insulator. In such a case, the antioxidants (A) and (B) are concentrated in the surface region, and thus a volume ratio of the inner region occupying most of the organic insulator can be increased. An increase in volume proportion of a portion having low content proportions of the antioxidants (A) and (B) can suppress a decrease in glass transition point (Tg) of the organic resin and increase heat resistance. A thickness ratio of the portion which has a layered shape and high content proportions of the antioxidants (A) and (B) is preferably from 0.05 to 0.3 when the thickness of the organic insulator is 1, although it depends on the thickness of the organic insulator. Also in this case, each of the antioxidants (A) and (B) is preferably uniformly dispersed in the surface region and the inner region of the organic insulator. A portion containing increased amounts of the antioxidants (A) and (B) is preferably the entire surface of the organic insulator, but, in some cases, may be provided only in a portion where maintenance of properties is required.

A method of mixing components including the nitrogen-based antioxidant (A) and the phenol-based antioxidant (B) when preparing the organic insulator is not particularly limited. Examples of the mixing method include a solution-mixing method in which all of the components are uniformly dissolved or dispersed in a solvent, and a melt-blending method in which all of the components are heated and mixed by an extruder or the like. Suitable solvents for use in the solution-mixing method include, for example, xylene. In this case, a mass ratio of the solid content (resin) to the solvent is not particularly limited, and is, for example, from about 60:40 to 20:80. Besides xylene, another solvent including an aromatic solvents such as toluene, benzene, or ethylbenzene; a hydrocarbon solvent such as normal hexane, cyclohexane, or methylcyclohexane; a ketone solvent such as acetone; tetrahydrofuran; or chloroform may be used, and xylene and such another solvent as described above may be used in combination.

Preferably, the organic resin is, for example, a resin composition containing: a cyclic olefin copolymer as a main component; and a peroxide. The peroxide preferably has a benzene ring. The cyclic olefin copolymer is preferably thermosetting. The application of a material containing a thermosetting cyclic olefin copolymer as a main component to the organic resin can provide an organic insulator having a low relative dielectric constant and a low dielectric loss tangent in a high frequency region. As for dielectric properties, for example, the relative dielectric constant and the dielectric loss tangent at 79 GHz and 125°C are 2.7 or less and 0.0045 or less, respectively.

The cyclic olefin copolymer is a polyolefin-based copolymer having a cyclic structure. Specifically, the cyclic olefin copolymer is a copolymer of a cyclic olefin and another monomer copolymerizable with the cyclic olefin. Proportions of the cyclic olefin and another monomer are not particularly limited. For example, the cyclic olefin may be contained in a proportion of from about 10 to 80 mass%, and another monomer may be contained in a proportion of from about 20 to 90 mass%. Examples of the cyclic olefin include a norbornene-based monomer, a cyclic diene-based monomer, and a vinyl alicyclic hydrocarbon-based monomer. Specific examples of the cyclic olefin include norbornene, vinylnorbornene, phenylnorbornene, dicyclopentadiene, tetracyclododecene, cyclopropene, cyclobutene, cyclopentene, cyclohexene, cyclohexadiene, and cyclooctadiene. These cyclic olefins may be used alone, or two or more thereof may be used in combination.

The thermosetting cyclic olefin copolymer preferably has a crosslinkable functional group in its molecule. Such a crosslinkable functional group is, for example, a group in which a crosslinking reaction can proceed by a radical derived from a peroxide having a benzene ring. The group can be, for example, at least one selected from the group consisting of a vinyl group, an allyl group, an acrylic group, and a methacrylic group.

The resin composition may further contain a monomer having at least two ethylenically unsaturated groups in its molecule. Such a monomer acts as a crosslinking agent between the cyclic olefin copolymers. This monomer is present in the resin composition in a state of having a small molecular weight, and thus is easy to enter between the cyclic olefin copolymers. Furthermore, the monomer is an organic molecule having two or more ethylenically unsaturated groups, and thus has a nature of easily reacting with crosslinkable sites of a plurality of adjacent cyclic olefin copolymers. This makes it possible to increase the glass transition point (Tg).

Examples of the monomer include tricyclodecane dimethanol diacrylate, tricyclodecane dimethanol dimethacrylate, and triallyl isocyanurate. Of these, tricyclodecane dimethanol diacrylate is suitable. When the resin composition contains tricyclodecane dimethanol diacrylate, the glass transition point (Tg) becomes 150°C or higher, and an increase rate of the dielectric loss tangent after being left at a high temperature can be reduced. In this case, a content proportion of the monomer is preferably 1 part by mass or more and 8 parts by mass or less with respect to 100 parts by mass of the cyclic olefin copolymer.

When such a monomer is present in the resin composition, the presence of the monomer between the cyclic olefin copolymers can provide a cured product in which the cyclic olefin copolymers are strongly crosslinked by its two or more ethylenically unsaturated groups. Specifically, a cured product (organic insulator) having a glass transition point (Tg) of 133°C or higher, preferably 136°C or higher after curing can be obtained. As for electrical properties, the relative dielectric constant (Dk) at a frequency of 79 GHz and room temperature (25°C) is 2.7 or less, and the dielectric loss tangent under the same conditions is 0.002 or less. Furthermore, with respect to the dielectric loss tangent (Df), a cured product (organic insulator) having a small dielectric loss tangent can be obtained even when it is left for a long period of time (for example, 2000 hours or more) in an environment at a temperature (for example, 125°C) higher than room temperature (25°C).

When the organic resin is formed of the cyclic olefin copolymer, a thermosetting cyclic olefin copolymer (thermosetting COC) is preferably used as a main component from the viewpoint of heat resistance.

The organic insulator of the present disclosure can suppress increases in relative dielectric constant and dielectric loss tangent even when exposed to a high temperature in an air atmosphere. As a result, the dielectric properties are stable even in a high-temperature environment. Therefore, in devices using a metal-clad substrate and a wiring board including the organic insulator, a decrease in performance can be suppressed even when they are used in a high-temperature environment, leading to an improvement in reliability.

The organic insulator described above may contain a filler (inorganic particles). Furthermore, the organic insulator described above may contain a flame retardant. For example, in a case of a large change in dielectric properties (relative dielectric constant and dielectric loss tangent) of the organic insulator either in a measurement frequency or in a measurement direction, transmission properties of a wiring board using the organic insulator in an insulating layer are likely to change over time. Therefore, an organic insulator, which has a low relative dielectric constant and a low dielectric loss tangent and which hardly change greatly both in measurement frequency and in measurement direction, is preferably used.

In order to obtain such an organic insulator, it is preferable to use a cyclic olefin copolymer having a crosslinking site with low polarity and low anisotropy, and to use a filler having an isotropic shape and a flame retardant. In this case, both the components preferably have a shape having an aspect ratio close to 1. The shapes of the filler and the flame retardant are preferably spherical or nearly spherical shapes. Here, the "nearly spherical shape" means a shape having a curved portion in a contour of the shape when the filler and the flame retardant are observed. For example, a proportion of the curved portion in the contour is 80% or more.

Silica is preferable as a material for the filler. That is, spherical silica is preferable. A flame retardant preferably contains a bromine component. That is, a bromine-based flame retardant is preferable.

Further, the filler and the flame retardant are preferably individually dispersed through the organic resin in the organic insulator. In particular, almost all of the flame retardant and the filler are preferably observed as particles with the organic resin interposed therebetween. Due to almost all of the flame retardant and the filler being observed as particles with the organic resin interposed therebetween, anisotropy of the dielectric properties of the organic insulator can be reduced, and isotropy can be enhanced.

This makes it possible to obtain an organic material having small frequency dependence of the relative dielectric constant/dielectric loss tangent and a small property difference between in a plane direction and in the thickness direction.

The organic insulator includes a cured resin containing a norbornene ring which has low polarity and is rigid. The cured resin containing a norbornene ring has a three dimensional structure, and thus its molecules are fixed to each other. Therefore, molecular motion is reduced.

The use of a bromine-based flame retardant and spherical silica also contributes to improvements in properties of the organic insulating material. In this case, the use of a nonpolar flame retardant and an isotropic spherical silica which does not exhibit anisotropy of the properties is preferable. Further, almost all of the flame retardant and the silica are preferably dispersed through the organic resin.

Thus, the anisotropy of the dielectric properties in the organic insulator can be reduced. When the organic insulator has a sheet shape, the difference in dielectric properties between in a planar direction and in the thickness direction can be reduced.

The organic resin may also contain a cured cyclic olefin copolymer having structures of nitrogen and di-t-butylphenol. The organic resin may contain a cured cyclic olefin copolymer having structures of nitrogen and di-t-butylphenol either within the same molecule or as a mixture of two molecules. A state where the organic resin contains a cured cyclic olefin copolymer having structures of nitrogen and di-t-butylphenol can be detected by pyrolysis GC-MS.

In the case of such an organic insulator (organic resin), the nucleophilic nitrogen site and the electrophilic phenol site interact with each other and are likely to be present in close proximity to each other. In this way, the molecules in the organic resin are easily fixed as a steric structure.

As a result, the molecules present inside the organic resin do not easily move even in response to a change in frequency of the applied electric power, and exhibit stable relative dielectric constant and dielectric loss tangent.

The use of such an organic insulator can provide a wiring board having small changes in dielectric properties even in response to a change in frequency or a change in direction of wiring formed inside the wiring board or on a surface thereof. In this case, the phrase "small changes in dielectric properties" means small changes in dielectric properties even in a case of different frequencies to be measured. In addition, the phrase "small changes in dielectric properties" means small changes in dielectric properties also between in the planar direction (in the X-Y plane) and in the thickness direction (Z direction) when the organic insulator has, for example, a sheet shape.

The metal-clad laminate sheet of the present disclosure includes a metal foil laminated on at least one surface of the organic insulator. As a result, the metal-clad laminate sheet has the dielectric properties exhibited by the organic insulator described above. In addition, the metal-clad laminate sheet has the properties such as oxidation resistance, adhesion to a metal foil, and insulating properties, which are possessed by the organic insulator.

The metal foil is not particularly limited, and examples thereof include copper foils such as electrolytic copper foil and rolled copper foil, aluminum foils, and composite foils obtained by superimposing these metal foils. Among these metal foils, a copper foil is preferable. A thickness of the metal foil is not particularly limited, and is preferably from about 5 to 105 $\mu$m, for example. In this case, a surface roughness Ra of the metal foil is preferably, for example, 0.5 $\mu$m or less, particularly 0.2 $\mu$m or less. In order to ensure adhesive force between the metal foil and the organic insulator, the surface roughness (Ra) is preferably 0.05 $\mu$m or more.

The metal-clad laminate sheet is obtained by superimposing a desired number of layers of each of the organic insulator and the metal foil, and performing heating and compression molding. When a metal-clad laminate sheet 100 has a dielectric loss tangent of, for example, 0.004 or less, sufficient electrical properties such as the relative dielectric constant are exhibited. Thus, the metal-clad laminate sheet 100 can be used, for example, as a wiring board for high frequency applications.

The wiring board of the present disclosure includes: a plurality of insulating layers; and a metal foil (conductor layer) disposed between the insulating layers, and each of the plurality of insulating layers preferably includes the organic insulator. The wiring board also has the properties such as dielectric properties, oxidation resistance, adhesion to a metal foil, flame retardancy, and insulating properties, which are possessed by the organic insulator.

The wiring board can be applied not only to a multilayer wiring board in which insulating layers and metal foils are alternately layered but also to a wiring board having a cavity structure. The wiring board can be obtained, for example, by: superimposing, on the metal-clad laminate sheet, a prepreg and an inner layer sheet in which a circuit and a through hole are formed; laminating a metal foil on a surface of the prepreg; and then performing heating (curing) and compression molding. Furthermore, the circuit and the through hole may be formed in the metal foil on the surface to thereby form a multilayer printed wiring board.

The wiring board can be obtained, for example, through steps of: preparing a resin composition serving as the organic insulator; molding the resin composition into a sheet to form a semi-cured insulating sheet; attaching a metal foil serving as a conductor layer to a surface of the insulating sheet; and heating and compressing the insulating sheet attached with the metal foil under predetermined conditions (temperature, pressure, and atmosphere). Since the insulating layer is formed of, for example, the organic insulator described above, the thus-obtained wiring board is suitable as a wiring board for high frequency applications having excellent long-term reliability.

Hereinafter, the organic insulator of the present disclosure will be specifically described with reference to Examples. The present disclosure is not limited to the Examples.

Example 1

For an organic resin, a thermosetting cyclic olefin copolymer having a crosslinkable functional group (manufactured by Mitsui Chemicals, Inc.) was used. As a peroxide having a benzene ring, PERBUTYL D (registered trademark, di-t-butyl peroxide, manufactured by NOF Corporation) was used. The organic resin had a composition obtained by adding 1.8 parts by mass of PERBUTYL D (peroxide) to 100 parts by mass of the cyclic olefin copolymer (COC).

As a nitrogen-based antioxidant (A), Chimassorb 2020 (hindered amine-based polymer, manufactured by BASF Japan Ltd.) was used.

As a phenol-based antioxidant (B), Irganox 1010 (di-t-butylphenol derivative manufactured by BASF Japan Ltd.) was used.

Next, the nitrogen-based antioxidant (A) and the phenol-based antioxidant (B) were blended in the composition obtained by adding PERBUTYL D (peroxide) to the cyclic olefin copolymer, in the proportions listed in Table 1 with respect to 100 parts by mass of the organic resin. The mixture was stirred at room temperature (25°C) to prepare a resin composition (Samples Nos. 1 to 13).

Next, the obtained resin composition was dissolved in xylene to obtain a resin varnish. The mass ratio of the resin composition to xylene was 40:60. The obtained resin varnish was molded into a sheet using a bar coater, and dried at 150°C for 4 minutes to obtain a sheet-shaped molded body having a thickness of 15 $\mu$m.

The obtained sheet-shaped molded body (hereinafter sometimes referred to as "sheet") was cut into small pieces. Six small pieces were superimposed and laminated, and copper foils each having a thickness of 18 $\mu$m were laminated on both surfaces thereof to prepare a laminated body.

Next, the laminated body was heated at 200°C for 120 minutes under a pressure of 4 MPa to obtain a copper-clad laminate sheet having a thickness of about 120 $\mu$m.

Then, the copper foils were peeled from the obtained copper-clad laminate sheet to taken out the organic insulator, and the relative dielectric constant Dk and the dielectric loss tangent Df at 79 GHz of the taken-out organic insulator were measured by a balanced-type circular disc resonator method. The relative dielectric constant Dk and the dielectric loss tangent Df were measured for each of the samples, at an initial stage (at room temperature of 25°C) and after being left at 125°C for 2000 hours. The results are indicated in Tables 1 and 2.

The obtained organic insulator was subjected to dynamic mechanical analysis (DMA) to measure the behavior of the loss tangent, and the peak temperature of the loss tangent was determined as the glass transition point (Tg). The results are indicated in Table 1.

The adhesive strength of the copper foil was measured using the prepared copper-clad laminate sheet. The peel strength of the copper foil was measured by pulling the copper foil in a direction perpendicular to the surface of the organic insulator using an autograph. An average value was determined using five samples. The results are indicated in Table 1.

[Table 1]

| Sample | Antioxidant (mass%) | | Nitrogen-based/ phenol-based ratio | Dk [79 GHz] | Df [79 GHz] | Tg (°C) | | Peel strength (kN/m) |
|---|---|---|---|---|---|---|---|---|
| | Nitrogen-based | Phenol-based | | | | Tg (<100°C) | Tg (>100°C) | |
| 1 | 0.3 | 0.6 | 0.5 | 2.708 | 0.0019 | 75 | 138 | 0.60 |
| 2 | 0.9 | 0.9 | 1.0 | 2.706 | 0.0019 | 74 | 137 | 0.60 |
| 3 | 0.8 | 0.5 | 1.6 | 2.702 | 0.0019 | 74 | 137 | 0.61 |
| 4 | 0.6 | 0.3 | 2.0 | 2.703 | 0.0019 | 75 | 137 | 0.62 |
| 5 | 3.0 | 1.5 | 2.0 | 2.708 | 0.0019 | 74 | 136 | 0.60 |
| 6 | 1.5 | 0.6 | 2.5 | 2.705 | 0.0019 | 75 | 139 | 0.60 |
| 7 | 0.9 | 0.3 | 3.0 | 2.710 | 0.0018 | 75 | 138 | 0.60 |
| 8 | 0.2 | 0.5 | 0.4 | 2.704 | 0.0019 | 74 | 137 | 0.61 |
| 9 | 3.1 | 1.0 | 3.1 | 2.720 | 0.0025 | 75 | 133 | 0.61 |
| 10 | 0.0 | 0.0 | - | 2.707 | 0.0016 | 74 | 141 | 0.61 |
| 11 | 0.3 | 0.0 | - | 2.700 | 0.0019 | 76 | 141 | 0.61 |
| 12 | 0.9 | 0.0 | - | 2.710 | 0.0019 | 75 | 139 | 0.50 |
| 13 | 0.0 | 0.9 | - | 2.696 | 0.0017 | 74 | 135 | 0.61 |

[Table 2]

| Sample | Antioxidant (%) | | Nitrogen-based/ phenol based ratio | Dk [79 GHz] after being left at 125°C | | Df [79 GHz] after being left at 125°C | |
|---|---|---|---|---|---|---|---|
| | Nitrogen-based | Phenol-based | | Initial stage | After 2000 hours | Initial stage | After 2000 hours |
| 1 | 0.3 | 0.6 | 0.5 | 2.708 | 2.729 | 0.0019 | 0.0034 |
| 2 | 0.9 | 0.9 | 1.0 | 2.706 | 2.738 | 0.0019 | 0.0036 |
| 3 | 0.8 | 0.5 | 1.6 | 2.702 | 2.734 | 0.0019 | 0.0035 |
| 4 | 0.6 | 0.3 | 2.0 | 2.703 | 2.729 | 0.0019 | 0.0033 |
| 5 | 3.0 | 1.5 | 2.0 | 2.708 | 2.737 | 0.0019 | 0.0038 |
| 6 | 1.5 | 0.6 | 2.5 | 2.705 | 2.730 | 0.0019 | 0.0034 |
| 7 | 0.9 | 0.3 | 3.0 | 2.710 | 2.736 | 0.0018 | 0.0037 |
| 8 | 0.2 | 0.5 | 0.4 | 2.704 | 2.760 | 0.0019 | 0.0045 |
| 9 | 3.1 | 1.0 | 3.1 | 2.720 | 2.740 | 0.0025 | 0.0040 |
| 10 | 0.0 | 0.0 | - | 2.707 | 2.925 | 0.0016 | 0.0090 |
| 11 | 0.3 | 0.0 | - | 2.700 | 2.816 | 0.0019 | 0.0072 |
| 12 | 0.9 | 0.0 | - | 2.710 | 2.742 | 0.0019 | 0.0041 |
| 13 | 0.0 | 0.9 | - | 2.696 | 2.902 | 0.0017 | 0.0087 |

As is clear from the results in Table 1, Samples Nos. 1 to 9 had a relative dielectric constant Dk at 79 GHz at the initial stage was 2.72 or less. Each of the samples had two glass transition points (Tgs) of lower than 100°C and 100°C or higher, and the glass transition point (Tg) on a high temperature side of 100°C or higher was 130°C or higher. The peel strength was 0.5 kN/m.

As is clear from the results in Table 2, Samples Nos. 1 to 9, in which the ratio (A/B) of the nitrogen-based antioxidant (A) to the phenol-based antioxidant (B) was 0.5 or more and 3.1 or less in terms of mass ratio, had a relative dielectric constant Dk and a dielectric loss tangent Df at 79 GHz after being left at 125°C for 2000 hours of 2.74 or less and 0.0045 or less, respectively.

In particular, when the ratio (A/B) between the antioxidants (A) and (B) was from 0.5 to 3.0 (Samples Nos. 1 to 7), the dielectric loss tangent Df at 125°C after 2000 hours was 0.0038 or less.

Further, when the total amount of the antioxidants (A) and (B) was from 0.9 to 2.1% (Samples Nos. 1 to 5 and 7), the dielectric loss tangent Df at 125°C after 2000 hours was 0.0037 or less.

Example 2

For the organic resin, a thermosetting cyclic olefin copolymer having a crosslinkable functional group (manufactured by Mitsui Chemicals, Inc.) was used. As the peroxide having a benzene ring, PERCUMYL D (registered trademark, dicumyl peroxide, manufactured by NOF Corporation) was used. The organic resin had a composition obtained by adding 1.4 parts by mass of PERCUMYL D (peroxide) to 100 parts by mass of the cyclic olefin copolymer (COC).

As the nitrogen-based antioxidant (A), Chimassorb 944 (hindered amine-based polymer, manufactured by BASF Japan Ltd.) was used.
As the phenol-based antioxidant (B), Irganox 1010 (di-t-butylphenol derivative manufactured by BASF Japan Ltd.) was used.

Next, the nitrogen-based antioxidant (A) and the phenol-based antioxidant (B) were blended in the composition obtained by adding PERCUMYL D (peroxide) to the cyclic olefin copolymer, in proportions of 0.6 parts by mass and 0.3 parts by mass, respectively, with respect to 100 parts by mass of the organic resin.

Further, a filler and a flame retardant were blended together with the antioxidants. A silica filler (SFP-30M manufactured by Denka Company Limited) was used as the filler, and a mixture obtained by mixing ethylenebispentabromobenzene and pentabromophenyl ether in a mass ratio of 1:1 was used as the flame retardant. Each of the filler and the flame retardant was added in an amount of 50 parts by mass with respect to 100 parts by mass of the cyclic olefin copolymer.

These components were stirred at room temperature (25°C) using a ball mill to obtain a resin varnish (Samples Nos. 14 to 26). The obtained resin varnish was molded into a sheet using a bar coater, and dried at 150°C for 4 minutes to obtain a sheet having a thickness of 40 $\mu$m.

The resins used in Samples Nos. 19 to 21 are as follows.

Liquid crystal polymer: RF-705 (Panasonic Corporation)
Fluororesin: polytetrafluoroethylene (PTFE) (RO3003 of Rogers Corporation)
Polyphenylene ether: R5410 (Panasonic Corporation)

The resulting sheet was cut into small pieces. Ten small pieces were superimposed and laminated, and a laminated body was heated at 200°C for 120 minutes under a pressure of 4 MPa to obtain a cured resin having a thickness of about 120 $\mu$m.

With respect to the obtained cured resin, the relationship between the measurement frequency and the relative dielectric constant/dielectric loss tangent was examined. The results are indicated in Table 3. In Table 3, the relative dielectric constant and the dielectric loss tangent were measured by a coaxial excitation balanced-type circular disc resonator method. The measurement direction was the Z direction. That is, the relative dielectric constant and the dielectric loss tangent were calculated from properties of resonance excited inside a balanced circular disc resonator which was electric-field-coupled from a central portion of a circular disc by a coaxial excitation line. Two 5 cm square pieces were used as samples.

From the measurement results, coefficients of variations in relative dielectric constant and dielectric loss tangent between at 15 GHz and at 79 GHz were determined, and the sample in which the coefficient of variation in relative dielectric constant was within 0.5% and the coefficient of variation in dielectric loss tangent was within 10% was ranked as being good. Each of the coefficients of variations was calculated from the following equation and expressed as an absolute value:

$$\text{Coefficient of variation} = [(\text{value at 79 GHz} - \text{value at 15 GHz})/15\ \text{GHz}] \times 100$$

Nitrogen and phenol were detected by pyrolysis GC-MS. Detection conditions are as follows.

<Detection conditions>

Heating condition: 600°C (in helium stream)
Pyrolyzer: DOUBLESHOT PYROLIZER PY2020iD manufactured by FRONTIER LAB GC-MS (gas chromatograph mass spectrometer): QP2010Plus manufactured by Shimadzu Corporation

The shape of the filler was observed with a microscope.
The dispersion state of the filler was evaluated by observing a cross section of the sample with a scanning electron microscope and identifying whether or not a plurality of fillers were aggregated in the sample.
Specifically, first, a particle diameter of each filler (silica) present in the sample was determined from the obtained photograph. At this time, the state in which an aggregate was present was a state in which a plurality of fillers gathered and were in contact with each other. A filler mass extracted as the aggregate had a diameter 10 times or more an average particle diameter of the fillers. The case where "an aggregate is present" refers to a case where a plurality of fillers gather and are in contact with each other, and at least one filler mass having a diameter 10 times or more the average particle diameter of the fillers is included in the observed region. The case where "the filler has a spherical shape" refers to a case where the filler has no linear portion in an observed contour thereof and has a curved entire circumference, under the condition that the aspect ratio is 1.3 or less.

The aspect ratio is a ratio of a length in a direction of the longest length (diameter) of the filler to a length in a direction perpendicular to the direction of the longest length (diameter) of the filler. The length in the direction perpendicular to the direction of the longest length (diameter) of the filler is referred to as the shortest diameter. The aspect ratio is a relationship of the longest diameter L1/the shortest diameter L2. The "polygonal" shape is a shape in which two or more linear portions are found in an observed contour of the filler.

[Table 3]

| Sample | Base material resin | Filler shape | Dispersion state | Nitrogen/ phenol ratio | Nitrogen detection | Phenol detection | Dielectric constant | | % Coefficient of variation | Dielectric loss tangent | | % Coefficient of variation |
|---|---|---|---|---|---|---|---|---|---|---|---|---|
| | | | | | | | 15GHz | 79GHz | | 15GHz | 79GHz | |
| 14 | Cyclic olefin copolymer | Spherical | Dispersed | 2.0 | ○ | ○ | 2.71 | 2.72 | 0.3 | 0.0020 | 0.0021 | 5.0 |
| 15 | Cyclic olefin copolymer | Spherical | Dispersed | 0.5 | ○ | ○ | 2.70 | 2.71 | 0.5 | 0.0018 | 0.0020 | 10.0 |
| 16 | Cyclic olefin copolymer | Spherical | Dispersed | 1.0 | ○ | ○ | 2.71 | 2.72 | 0.4 | 0.0020 | 0.0022 | 7.5 |
| 17 | Cyclic olefin copolymer | Spherical | Dispersed | 3.0 | ○ | ○ | 2.71 | 2.72 | 0.5 | 0.0021 | 0.0023 | 10.0 |
| 18 | Cyclic olefin copolymer | Spherical | Dispersed | 0.7 | ○ | ○ | 2.70 | 2.72 | 0.4 | 0.0019 | 0.0021 | 7.9 |
| 19 | Fluororesin | Polygonal | Dispersed | - | × | × | 3.04 | 3.03 | 0.3 | 0.0007 | 0.0010 | 42.9 |
| 20 | Liquid crystal polymer | - | - | - | × | × | 2.92 | 2.92 | 0.0 | 0.0019 | 0.0035 | 84.2 |
| 21 | Polyphenylene ether | Spherical | Dispersed | - | × | × | 3.09 | 3.10 | 0.3 | 0.0019 | 0.0030 | 57.9 |
| 22 | Cyclic olefin copolymer | Spherical | Dispersed | - | ○ | × | 2.70 | 2.71 | 0.4 | 0.0016 | 0.0019 | 18.8 |
| 23 | Cyclic olefin copolymer | Spherical | Dispersed | - | × | ○ | 2.67 | 2.69 | 0.7 | 0.0016 | 0.0017 | 11.6 |
| 24 | Cyclic olefin copolymer | Spherical | Dispersed | 0.4 | ○ | ○ | 2.69 | 2.71 | 0.7 | 0.0018 | 0.0020 | 11.1 |
| 25 | Cyclic olefin copolymer | Spherical | Dispersed | 3.1 | ○ | ○ | 2.71 | 2.74 | 1.1 | 0.0021 | 0.0024 | 11.9 |
| 26 | Cyclic olefin copolymer | Spherical | Aggregated | 2 | ○ | ○ | 2.71 | 2.72 | 0.4 | 0.0020 | 0.0021 | 5.0 |

From Table 3, it can be seen that Samples Nos. 14 to 18 have a smaller variation in dielectric loss tangent due to the frequency than that of Samples Nos. 19 to 26.

With respect to the cured resin obtained above, the relationship between the measurement direction and the relative dielectric constant/dielectric loss tangent was examined. The results are indicated in Table 4. In Table 4, the measurement wavelengths were all 79 GHz. The relative dielectric constant and the dielectric loss tangent in the XY direction were measured by a cavity cylindrical resonator method, and those in the Z direction were measured by the coaxial excitation balanced-type circular disc resonator method. In the cavity cylindrical resonator method, a dielectric substrate (sample) is held between cylindrical cavity resonators divided at the center. The relative dielectric constant and dielectric loss tangent are calculated from resonance properties of the resonator. One 5 cm square piece was used as a sample.

The sample in which the coefficient of variation in relative dielectric constant between in the XY direction and in the Z direction was within 1% and the coefficient of variation in dielectric loss tangent between in the XY direction and in the Z direction was within 10% was ranked as being good. Each of the coefficients of variations was calculated from the above equation. The other matters are the same as those for the measurement method indicated in Table 3.

[Table 4]

| Sample | Base material resin | Filler shape | Dispersion state | Nitrogen detection | Phenol detection | Dielectric constant | | Coefficient of variation | Dielectric loss tangent | | Variation |
|---|---|---|---|---|---|---|---|---|---|---|---|
| | | | | | | XY direction | Z direction | | XY direction | Z direction | |
| 14 | Cyclic olefin copolymer | Spherical | Dispersed | ○ | ○ | 2.70 | 2.72 | 0.7 | 0.0021 | 0.0020 | 4.8 |
| 15 | Cyclic olefin copolymer | Spherical | Dispersed | ○ | ○ | 2.69 | 2.72 | 1.0 | 0.0021 | 0.0019 | 10.0 |
| 16 | Cyclic olefin copolymer | Spherical | Dispersed | ○ | ○ | 2.69 | 2.72 | 0.9 | 0.0021 | 0.0019 | 9.5 |
| 17 | Cyclic olefin copolymer | Spherical | Dispersed | ○ | ○ | 2.69 | 2.72 | 1.0 | 0.0022 | 0.0020 | 10.0 |
| 18 | Cyclic olefin copolymer | Spherical | Dispersed | ○ | ○ | 2.68 | 2.71 | 0.9 | 0.0022 | 0.0020 | 9.1 |
| 19 | Liquid crystal polymer | Polygonal | Dispersed | × | × | 3.47 | 2.91 | 16.1 | 0.0029 | 0.0039 | 34.5 |
| 20 | Fluororesin | - | - | × | × | 3.11 | 2.98 | 4.2 | 0.0009 | 0.0010 | 11.1 |
| 21 | Polyphenylene ether | Spherical | Dispersed | × | × | 3.15 | 3.13 | 0.6 | 0.0032 | 0.0035 | 9.4 |
| 22 | Cyclic olefin copolymer | Spherical | Dispersed | ○ | × | 2.72 | 2.71 | 0.4 | 0.0018 | 0.0019 | 5.6 |
| 23 | Cyclic olefin copolymer | Spherical | Dispersed | × | ○ | 2.70 | 2.665 | 1.3 | 0.0015 | 0.0017 | 13.3 |
| 24 | Cyclic olefin copolymer | Spherical | Dispersed | ○ | ○ | 2.68 | 2.71 | 1.1 | 0.0023 | 0.0020 | 11.1 |
| 25 | Cyclic olefin copolymer | Spherical | Dispersed | ○ | ○ | 2.68 | 2.72 | 1.7 | 0.0024 | 0.0021 | 12.5 |
| 26 | Cyclic olefin copolymer | Spherical | Aggregated | ○ | ○ | 2.65 | 2.72 | 2.6 | 0.0022 | 0.0020 | 9.1 |

Table 4 indicates that Samples Nos. 14 to 18 have a smaller variation in dielectric loss tangent due to the measurement direction than that of Samples Nos. 19 to 26.

**Claims**

1.  An organic insulator comprising an organic resin as a main component, the organic resin comprising at least a nitrogen atom-containing antioxidant (A) and a phenol-based antioxidant (B).

2.  The organic insulator according to claim 1, wherein a ratio (A/B) of the nitrogen atom-containing antioxidant (A) to the phenol-based antioxidant (B) is 0.5 or more and 3.1 or less in terms of mass ratio.

3.  The organic insulator according to claim 2, wherein the ratio (A/B) of the nitrogen atom-containing antioxidant (A) to the phenol-based antioxidant (B) is 0.5 or more and 3.0 or less in terms of mass ratio.

4.  The organic insulator according to any one of claims 1 to 3, wherein a total amount of the nitrogen atom-containing antioxidant (A) and the phenol-based antioxidant (B) is 0.9 parts by mass or more and 4.5 parts by mass or less with respect to 100 parts by mass of the organic resin.

5.  The organic insulator according to claim 4, wherein the total amount of the nitrogen atom-containing antioxidant (A) and the phenol-based antioxidant (B) is 0.9 parts by mass or more and 2.1 parts by mass or less with respect to 100 parts by mass of the organic resin.

6.  The organic insulator according to any one of claims 1 to 5, wherein content proportions of the nitrogen atom-containing antioxidant (A) and the phenol-based antioxidant (B) are higher in a surface region than in an inner region.

7.  The organic insulator according to any one of claims 1 to 6, wherein the nitrogen atom-containing antioxidant (A) is a hindered amine-based compound, and the phenol-based antioxidant (B) is a di-t-butylphenol derivative.

8.  The organic insulator according to any one of claims 1 to 7, wherein the organic resin comprises a thermosetting resin.

9.  The organic insulator according to claim 8, wherein a main component of the thermosetting resin is a cyclic olefin copolymer.

10. The organic insulator according to any one of claims 1 to 9, further comprising a spherical silica filler and a bromine-based flame retardant.

11. A metal-clad laminate sheet comprising: the organic insulator described in any one of claims 1 to 10; and a metal foil laminated on at least one surface of the organic insulator.

12. A wiring board comprising: a plurality of insulating layers, each of the plurality of insulating layers comprising the organic insulator described in any one of claims 1 to 10; and a metal foil disposed between the insulating layers.

## INTERNATIONAL SEARCH REPORT

| International application No. |
| --- |
| **PCT/JP2022/019184** |

**A. CLASSIFICATION OF SUBJECT MATTER**

*H01B 17/56*(2006.01)i; *H05K 1/03*(2006.01)i

FI: H01B17/56 Z; H05K1/03 610H; H05K1/03 630H

According to International Patent Classification (IPC) or to both national classification and IPC

**B. FIELDS SEARCHED**

Minimum documentation searched (classification system followed by classification symbols)

H01B17/56; H05K1/03

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2020-15812 A (YAZAKI CORP.) 30 January 2020 (2020-01-30)<br>        paragraphs [0063]-[0076] | 1-5, 10 |
| A | | 6, 11-12 |
| X | JP 2020-532604 A (DOW GLOBAL TECHNOLOGIES LLC) 12 November 2020 (2020-11-12)<br>        paragraphs [0083]-[0100], table 1 | 1-3, 7 |
| A | | 6, 11-12 |
| X | JP 2016-74220 A (OJI HOLDINGS CORP.) 12 May 2016 (2016-05-12)<br>        paragraphs [0018], [0049] | 1, 4-5, 8-9 |
| A | | 6, 11-12 |
| A | JP 2013-71960 A (SEKISUI CHEM. CO., LTD.) 22 April 2013 (2013-04-22)<br>        paragraphs [0119]-[0127], [0186]-[0188] | 6, 11-12 |

☐ Further documents are listed in the continuation of Box C.     ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **05 July 2022** | **12 July 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/019184**

| Patent document cited in search report | | | Publication date (day/month/year) | Patent family member(s) | Publication date (day/month/year) |
|---|---|---|---|---|---|
| JP | 2020-15812 | A | 30 January 2020 | (Family: none) | |
| JP | 2020-532604 | A | 12 November 2020 | WO 2019/046159 A1 paragraphs [0083]-[0101] | |
| JP | 2016-74220 | A | 12 May 2016 | (Family: none) | |
| JP | 2013-71960 | A | 22 April 2013 | (Family: none) | |

Form PCT/ISA/210 (patent family annex) (January 2015)

**REFERENCES CITED IN THE DESCRIPTION**

**Patent documents cited in the description**

- JP 2010100843 A